# EUROPÄISCHE PATENTSCHRIFT

(11) **EP 1 918 668 B1**
(45) Veröffentlichungstag und Bekanntmachung des Hinweises auf die Patenterteilung: **02.06.2010**
(21) Anmeldenummer: 07018356.1
(22) Anmeldetag: 19.09.2007
(51) Int. Cl.: F28D 15/02, H01L 23/427, H05K 7/20

(54) **Vorrichtung zur Aufnahme eines Fluids mittels Kapillarkräften und Verfahren zur Herstellung der Vorrichtung**
Device for absorbing a fluid via capillary forces and method for manufacturing the device
Dispositif destiné à la réception d'un fluide à l'aide de forces capillaires et procédé destiné à la fabrication du dispositif

(30) Priorität: 27.10.2006 DE 102006051427
(43) Veröffentlichungstag der Anmeldung: 07.05.2008
(73) Patentinhaber: Behr GmbH & Co. KG, 70469 Stuttgart (DE)
(72) Erfinder: Burk, Roland, Dipl.-Phys., 70469 Stuttgart (DE); Zwittig, Eberhard, Dipl.-Ing., 73269 Hochdorf (DE)

(56) Entgegenhaltungen:
- WO-A-2006/074583
- JP-A- 2002 016 201
- US-A- 3 673 846
- US-A- 5 505 257
- US-A- 5 871 043
- US-A1- 2003 159 806
- US-B1- 6 216 343

## Beschreibung

Die Erfindung betrifft eine Vorrichtung zur Aufnahme eines Fluids mittels Kapillarkräften nach dem Oberbegriff des Anspruchs 1 sowie ein Verfahren zu dessen Herstellung gemäß den Merkmalen des Anspruchs 14. So eine Vorrichtung ist aus JP-A-2002 16201 bekannt. Die Erfindung betrifft zudem ein Wärmerohr oder Sorptionsrohr nach dem Oberbegriff des Anspruchs 20 sowie eine Kühlvorrichtung zur Kühlung einer Elektronikkomponente nach dem Oberbegriff des Anspruchs 21.

Allgemein sind aus dem Stand der Technik Wärmerohre und nach dem Prinzip eines Wärmerohrs aufgebaute Kühlvorrichtungen bekannt, bei denen ein in einem ersten Raumbereich verdampfendes und in einem entfernten Raumbereich kondensierendes Fluid, z.B. Wasser, Alkohol oder ähnliches, über Kapillarkräfte zwischen den Bereichen transportiert wird. Die kapillarisch wirksamen Strukturen werden z.B. durch Sintern von feinem Metallgranulat hergestellt. Ebenso ist bekannt, Gewebe, Gestricke, Gittemetze und andere Strukturen einzusetzen. Neben der Aufnahme und gegebenenfalls dem Transport von Flüssigkeit haben solche Strukturen häufig auch den Zweck der Ausbildung von Blasenkeimen zur Kontrolle eines Siedevorgangs der Flüssigkeit und zur Verbesserung der Kondensation.

Weiterhin sind Sorptionsrohre bekannt, bei denen eine Seite des sonst analog zum Wärmerohr aufgebauten Rohres mit einer Sorptionsmittelbeschichtung statt mit einer Kapillarstruktur ausgestattet ist. Sowohl Wärme- als auch Sorptionsrohre benötigen wenigstens auf einer Seite eine Vorrichtung zum wandnahen Halten und Transport eines Fluids mittels Kapillarkräften.

Es ist die Aufgabe der Erfindung, eine Vorrichtung zur Aufnahme eines Fluids mittels Kapillarkräften anzugeben, die kostengünstig herstellbar ist und eine hohe Porosität aufweist. Die hohe Porosität wird benötigt, um eine große Menge flüssigen Arbeitsmittels zu speichern und im thermischen Wandkontakt zu halten.

Diese Aufgabe wird für eine eingangs genannte Vorrichtung zur Aufnahme eines Fluids mittels Kapillarkräften erfindungsgemäß mit den kennzeichnenden Merkmalen des Anspruchs 1 gelöst. Durch die Ausbildung einer Vielzahl von Faltungen in einem Blechformteil lassen sich bei entsprechender Dichte der Faltungen ausreichend kleine Räume zwischen benachbarten Faltungen ausbilden, um das betreffende Fluid in diesen Räumen durch Kapillarkräfte zu verteilen. Neben günstiger Herstellbarkeit und hoher Porosität kann hierdurch auch die Verdampfung und Kondensation des Fluids verbessert werden. Unter dem Begriff "Blechformteil" soll erfindungsgemäß auch ein Metallfolienformteil beziehungsweise ein daraus hergestelltes Halbzeug, beispielsweise ein Streckgitter verstanden werden.

In bevorzugter Ausführung ist das Element stoffschlüssig mit der Oberfläche verbunden, insbesondere mittels Verlötung, Verschweißung oder Verklebung. Hierdurch läßt sich insbesondere ein guter thermischer Kontakt zwischen dem Element bzw. Blechformteil und der Oberfläche bzw. dem Tragteil herstellen. Das Element kann dabei je nach Dimensionierung in ausreichendem Umfang biegbar sein, um eine Anpassung an die Form der insbesondere im Wesentlichen glatten Oberfläche zu ermöglichen.

Die Faltungen weißen jeweils parallel zueinander verlaufende Wandabschnitte auf. Durch entsprechend enge Beabstandung dieser Wandabschnitte lassen sich auf einfache Weise kapillarisch wirksame Hohlräume erzeugen, wobei zudem eine hohe Porosität, d.h. ein großes Verhältnis von Hohlraum zu Materialvolumen, erreichbar ist.

Die Wandabschnitte sind jeweils in einem Winkel zu der Oberfläche ausgerichtet, wobei der Winkel weniger als 90° beträgt. Im Hinblick auf ein einfaches Herstellungsverfahren lässt sich auf diese Weise eine erfindungsgemäße Vorrichtung kostengünstig bereitstellen, da der geringe Abstand benachbarter Faltungswände einfach durch einen Herstellungsschritt des Umlegens der Faltungen erzielbar ist. Der Winkel beträgt dabei bevorzugt weniger als 45°, besonders bevorzugt weniger als 25°.

In dem Blechformteil ist eine Mehrzahl von Durchbrechungen ausgebildet. Hierdurch ist ein Fluidtransport durch das Blech hindurch und somit auch in anderen Raumrichtungen als in Längsrichtung der Faltungen ermöglicht. Die Durchbrechungen sind zudem geeignet, als Anschlag den Abstand zwischen benachbarten Faltungswänden zu definieren. Die Durchbrechungen können zum Beispiel in Form von kiemenförmiger Ausstellungen sein. In bevorzugter Detail ausführung sind auch Vorsprünge, zum Beispiel in Form von Noppen, vorgesehen.

In einer vorteilhaften Ausführungsform weist das Blechformteil Stegrippen auf. Stegrippen sind -ähnlich wie zum Beispiel Kiemenrippen- einfach herstellbar und haben gute Transporteigenschaften aufgrund der Durchbrechungen zwischen benachbarten Faltungen.

Bevorzugt besteht das Blechformteil aus einem gut wärmeleitenden Metall, insbesondere auf Basis von Kupfer. Neben der guten Wärmeleitung ist Kupfer gut formbar, so dass die eng beabstandeten Faltungen der erfindungsgemäßen Vorrichtung einfach herstellbar sind.

In einer geeigneten Ausführungsform besteht das Blechformteil aus einem Blech, bevorzugt einem Metallband, dessen Dicke weniger als etwa 0,1 mm und besonders bevorzugt weniger als etwa 0,03 mm beträgt. Solche Bleche sind mit hoher Prozeßsicherheit zu einer erfindungsgemäßen Vorrichtung formbar.

In vorteilhafter Gestaltung einer Ausführungsform weist das Blechformteil eine Oberflächenbehandlung oder eine Beschichtung mit guter Benetzbarkeit durch das Fluid auf, wodurch im Falle einer ungünstigen Materialpaarung von Fluid und Blechmaterial der kapillarische Transport des Fluids verbessert werden kann. Die Oberfläche kann beispielsweise eine spezifische Oxidschicht oder dergleichen aufweisen.

Die Faltungen haben eine Dichte von zwischen etwa 150 und etwa 800 Faltungen/dm, besonders bevorzugt zwischen etwa 200 und etwa 500 Faltungen/dm. Weiterhin vorteilhaft haben die Faltungen eine Höhe über der Oberfläche zwischen etwa 1 mm und etwa 6 mm, besonders bevorzugt zwischen etwa 1 mm und etwa 3 mm.

Ein erfindungsgemäßes Verfahren zur Herstellung einer Vorrichtung nach einem der Ansprüche 1 bis 13 umfaßt die Schritte gemäß dem Anspruch 14. Auf diese Weise ist das mehrfach gefaltete Element einer erfindungsgemä-ßen Vorrichtung einfach und kostengünstig herstellbar, insbesondere durch ein Quasi-Endlos-Verfahren. Dabei kann das Blech von einer beliebig großen Rolle bereitgestellt werden, wobei über geeignete Mittel wie etwa Walzen die entsprechenden Faltungen, Durchbrechungen und/oder Ausprägungen kontinuierlich eingebracht werden. Aus dem so gefalteten Blechformteil können zum Beispiel Stücke geeigneter Größe ausgeschnitten und gemäß Schritt c. auf die Oberfläche des Tragteils aufgebracht werden. Bei dem Tragteil kann es sich ebenfalls um ein Blechteil von einer Rolle handeln, so dass die Aufbringung des gefalteten Blechteils auf das Tragteil alternativ auch als kontinuierlicher Vorgang ausgestaltet sein kann.

Das Verfahren umfasst ferner ein Komprimieren der in Schritt b. erzeugten Faltungen. Hierdurch ist auf einfache Weise ein zur Erzeugung von Kapillarkräften ausreichend kleiner Abstand benachbarter Faltungen erreichbar. In einer Ausführung können die Faltungswände zumindest abschnittsweise unmittelbar aneinander anliegen.

In einer bevorzugten Ausführungsform erfolgt das zumindest teilweise Komprimieren vor Schritt c. Alternativ oder ergänzend erfolgt das Komprimieren nach Schritt c. Die Faltungen werden bezüglich der Oberfläche umgelegt, um Zwischenräume zwischen benachbarten Faltungswänden zu verringern. Durch diesen Herstellungsschritt ist auf einfache und effektive Weise die Verkleinerung der Zwischenräume zwischen benachbarten Faltungen ermöglicht. Zudem wird hierdurch die Bauhöhe des gefalteten Blechformteils im Allgemeinen verringert. Vorteilhaft kann das Komprimieren bzw. Umlegen dabei mittels eines Walzvorgangs erfolgen.

In einer weiteren alternativen oder ergänzenden Abwandlung erfolgt das Komprimieren der in Schritt b. erzeugten Faltungen zumindest teilweise durch ein Umlegen der Faltungen vor einem Aufbringen nach Schritt c. Dabei können die Faltungen auch eine teilweise Komprimierung vor dem Umlegen erfahren. Das Umlegen vor dem Aufbringen nach Schritt c. kann zum Beispiel durch Auflegen des gefalteten Blechformteils auf einer bevorzugt rauen Unterlage und nachfolgendes Walzen erfolgen. Diese so kontrolliert vorgefertigte Struktur kann dann gemäß Schritt c. auf die Oberfläche des Tragteils aufgebracht werden.

Regelmäßig, aber nicht notwendig im Sinne der Erfindung wird -sofern überhaupt vorgesehen- das Umlegen der Faltungen um einen umso größeren Umlenkwinkel erfolgen, je kleiner die vor dem Umlegen bestehende Dichte der Faltungen ist.

Allgemein vorteilhaft umfasst das Verfahren zudem den Schritt des Einbringens von Vorsprüngen und in das Blech, insbesondere vor oder bei dem Durchführen von Schritt b. Die Vorsprünge und Durchbrechungen können besonders einfach mittels eines Walzvorgangs oder eines Schneid- oder Umformvorgangs in das Blech eingebracht werden, bevor die Faltung erfolgt.

Vor dem Schritt b kann die Metallfolie also schon zu einem bandförmigen Halbzeug mit entsprechender Strukturierung vorliegen. Bevorzugt besitzt das plissierte Bandmaterial auch Durchbrüche und Öffnungen im Bereich der Faltenkämme, um Aus- und Zutrittsquerschnitte für das ab- und zuströmenden Fluid bereitzustellen.

Die Erfindung betrifft zudem ein Wärmerohr mit den Merkmalen des Anspruchs 20. Durch die Anordnung der erfindungsgemäßen Vorrichtung als Mittel zum Transport des Fluids in dem Wärmerohr ist eine kostengünstige Alternative zu bekannten Wärmerohren bereitgestellt, wobei sich die besonderen Eigenschaften der erfindungsgemäßen Vorrichtung, zum Beispiel die große Porosität, je nach Anforderungen vorteilhaft auf die Funktion auswirkt.

Die Erfindung betrifft weiterhin eine Kühlvorrichtung zur Kühlung einer Elektronikkomponente gemäß den Merkmalen des Anspruchs 21. Grundsätzlich ist es bekannt, Kühlvorrichtungen mit einem verdampfenden und kondensierenden Fluid an Elektronikkomponenten wie zum Beispiel Mikroprozessoren und anderen Bauteilen mit hoher Leistungsdichte anzubringen. Durch die Anordnung der erfindungsgemäßen Vorrichtung in dem Hohlraum des Gehäuses läßt sich eine solche Kühlvorrichtung hinsichtlich Kosten und Leistungsfähigkeit verbessern.

Bevorzugt umfasst der Hohlraum eine Verdampfungsfläche zur Verdampfung des Fluids, wobei die Mittel zur Aufnahme des Fluids an der Verdampfungsfläche angeordnet sind. Hierdurch wird auf einfache Weise eine gleichmäßige Verteilung des Fluids über die Verdampfungsfläche und somit eine homogene Kühlleistung über die Fläche sichergestellt. Besonders vorteilhaft ist dabei ein Teil der Verdampfungsfläche geneigt, insbesondere im Wesentlichen senkrecht, angeordnet. Hierdurch kann auch der mit der Elektronikkomponente verbundene Wandabschnitt eine entsprechende Neigung und insbesondere senkrechte Ausrichtung aufweisen, so dass die Kühlvorrichtung auch mit zum Beispiel senkrecht montierten Mikroprozessoren kombiniert werden kann.

Allgemein bevorzugt ist zur Verbesserung der Kühlleistung eine äußere Berippung zum Austausch von Wärme mit Luft an dem Gehäuse angeordnet. Besonders bevorzugt umfaßt die Vorrichtung dabei einen Lüfter zur Beströmung des Gehäuses mit Luft.

Weiterhin vorteilhaft ist in dem Gehäuse eine kühlbare Kondensationsfläche angeordnet, wobei dampfförmiges Fluid vorrangig an der Kondensationsfläche kondensiert. Im Interesse einer kostengünstigen Herstellung kann dabei die Kondensationsfläche im Wesentlichen glatt sein. Insbesondere kann es vorgesehen sein, dass an der Kondensationsfläche keine Strukturen zur Aufnahme von Flüssigkeiten mittels Kapillarkräften angeordnet sind. Hierbei kann kostengünstig und dennoch effektiv die kondensierte Flüssigkeit von der insbesondere glatten Kondensationsfläche abtropfen oder zurücklaufen, wobei sie im Bereich der Verdampfungsfläche mittels der kapillarischen Struktur aufgenommen und verteilt wird.

Nachfolgend werden mehrere Ausführungsbeispiele einer erfindungsgemäßen Vorrichtung beschrieben und anhand der anliegenden Zeichnungen näher erläutert.
- Fig. 1: zeigt eine schematische räumliche Darstellung eines ersten Ausführungsbeispiels einer erfindungsgemäßen Vorrichtung in drei verschiedenen Stufen einer Herstellung der Vorrichtung.
- Fig. 2: zeigt eine schematische Darstellung einer Vorrichtung nach dem Stand der Technik mit verschiedenen Vorsprüngen und Durchbrechungen.
- Fig. 3: zeigt ein weiteres Ausführungsbeispiel der Erfindung, mit definiertem Abstand benachbarter Faltungen.
- Fig. 4: zeigt eine Vorrichtung nach dem Stand der Technik.
- Fig. 5: zeigt eine Vorrichtung nach dem Stand der Technik mit Faltungen in Form von Stegrippen.
- Fig. 6: zeigt eine Vorrichtung nach dem Stand der Technik zur Kühlung einer Elektronikkomponente in einer seitlichen Schnittansicht.
- Fig. 7: zeigt eine Draufsicht auf die Kühlvorrichtung aus Fig. 6 von hinten.
- Fig.8: zeigt eine Abwandlung der Vorrichtung aus Fig. 6.
- Fig. 9: zeigt eine Draufsicht auf der Vorrichtung aus Fig. 8 von hinten.
- Fig. 10: zeigt eine Vorrichtung nach dem Stand der Technik in einer seitlichen Schnittansicht.
- Fig. 11 1: zeigt die Kühlvorrichtung aus Fig. 10 in einer Draufsicht von hinten.

Die erfindungsgemäße Vorrichtung zur Aufnahme eines Fluids mittels Kapillarkräften gemäß dem ersten Ausführungsbeispiel umfasst ein Blechformteil 1, das mittels flächiger Verlötung auf der Oberfläche eines Tragteils 2 festgelegt ist.

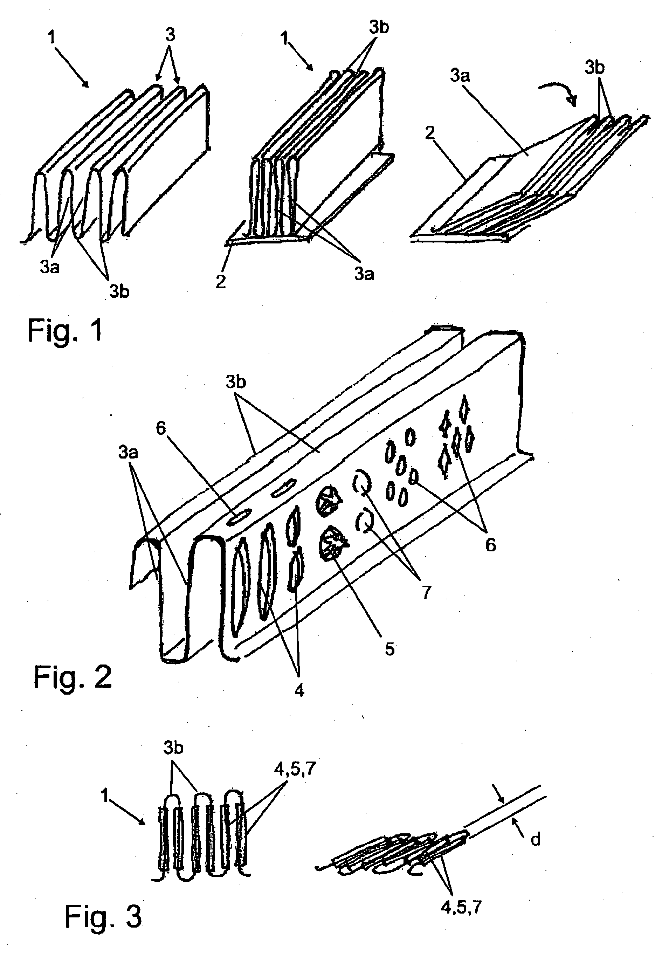

Im Zuge der Herstellung wird zunächst ein Blech von einer quasi-endlosen Rolle mittels Walzen alternierend gefaltet (siehe linke Abbildung der Fig. 1). Bei dem Blech handelt es sich vorliegend um ein Kupferblech mit einer Dicke von 0,025mm. Das Blechformteil 1 umfasst nach diesem Umformschritt benachbarte Faltungen 3, die jeweils einen im Wesentlichen geraden Wandabschnitt 3a und einen Umbiegungsbereich 3b aufweisen. Die Herstellung der Faltungen 3 kann so erfolgen, dass zunächst eine etwas flachere Wellenstruktur mittels Walzung in das Blech eingebracht wird und nachfolgend eine Komprimierung oder Raffung in Führungsrichtung des Bleches erfolgt, so dass die Wandabschnitte 3a benachbarter Faltungen annähernd parallel zueinander ausgerichtet sind.

Das Blechformteil 1 wird nachfolgend mittels flächiger Verlötung oder einer anderen stoffschlüssigen Verbindung auf das Tragteil 2 aufgebracht (siehe mittlere Abbildung in Fig. 1), wobei die Wandabschnitte 3a der Faltungen zunächst im Wesentlichen senkrecht zu dem Tragteil 2 ausgerichtet sind. Bei dem Tragteil 2 handelt es sich vorliegend um ein quasi-endloses Blech von einer Rolle, das eine etwas größere Dicke als das Blechformteil 1 aufweist.

Nach der flächigen Verlötung, durch die ein guter thermischer Kontakt zwischen Blechformteil 1 und Tragteil 2 hergestellt wird, werden die Faltungen 3 des Blechformteils 1 in einer Richtung umgelegt oder gekippt (siehe rechte Abbildung in Fig. 1), was durch einen einfachen Walzvorgang oder einen Pressvorgang erfolgen kann. Durch das Umlegen des Blechformteils 1 werden die Abständen zwischen benachbarten Wandabschnitten 3a der Faltungen so stark verringert, so dass die verbleibenden Zwischenräume als Kapillaren auf ein Fluid wirken können. Das Blechformteil 1 kann zum Beispiel bis zu einem Winkel zum Tragteil 2 von weniger als 20° umgelegt werden..

Insgesamt wird hierdurch ein flächiges Element bereitgestellt, das zur Aufnahme und zum Transport eines Fluids mittels Kapillarkräften geeignet ist. Das Tragteil 2 kann ein Blech sein, so dass das Element mittels des Tragteils 2 an einer anderen Struktur festlegbar ist. Alternativ handelt ist das Tragteil 2 unmittelbar eine Gehäusewand, zum Beispiel eines Wärmerohrs oder einer Kühlvorrichtung.

In einem abgewandelten Herstellungsverfahren kann in Abweichung von der zuvor beschriebenen und in Fig. 1 gezeigten Herstellung auch ein Umlegen der Faltungen erfolgen, bevor das Blechformteil 1 auf das Tragteil 2 aufgebracht wird. Das gefaltete Blechteil kann hierzu auf eine geeignete Unterlage aufgelegt und dann gewalzt werden. Die Unterlage ist bevorzugt ausreichend rau, um die sie berührenden Bereiche des Blechformteils lateral zu halten. Das Blechformteil wird dann erst nach dem Vorgang des Umlegens auf das eigentliche Tragteil 2 aufgebracht, zum Beispiel mittels Verlötung.

Fig. 2 zeigt eine Vorrichtung nach dem Stand der Technik, bei der zusätzlich zu der Ausführung nach Fig. 1 vor der Faltung des Blechformteils 1 Strukturen in das Blech eingebracht wurden, zum Beispiel mittels eines Walzvorgangs mit strukturierten Walzen. Bei den Strukturen kann es sich um nicht durchbrochene Vorsprünge oder auch um Durchbrechungen des Blechs 1 handeln. In Fig. 2 sind exemplarisch verschiedene solcher Strukturen dargestellt. Gezeigt sind längliche Durchbrechungen in Form von Kiemen 4, runde Durchbrechungen mit Ausstellungen 5, die zum Beispiel durch eine Stachelwalze einbringbar sind, beliebig geformte Durchbrechungen ohne Vorsprung 6, die zum Beispiel mittels Stanzung herstellbar sind sowie eingeprägte Noppen 7, die lediglich einen Vorsprung in der Blechebene ausformen, das Blech 1 jedoch nicht durchbrechen.

Über die Durchbrechungen kann das Fluid nicht nur in Längsrichtung der Faltungen transportiert werden, sondern auch quer dazu, indem es die Durchbrechungen in den Wandabschnitten 3a und den Umbiegungsbereichen 3b der Faltungen durchströmt. Durch die noppenartigen Vorsprünge 7 ist unter anderem eine Festlegung des Abstandes benachbarter Wandabschnitte 3a der Faltungen erzielbar.

Fig. 3 zeigt eine Schnittansicht eines weiteren Ausführungsbeispiels, bei dem mittels Vorsprüngen oder vorspringenden Durchbrechungen 4, 5, 7 im umgelegten Zustand des Blechformteils 1 ein Abstand d benachbarter Wandabschnitte 3a der Faltungen 3 definiert wird. Die über die Blechebene vorstehenden Strukturen 4, 5, 7 liegen dabei jeweils an dem Wandabschnitt 3a der benachbarten Faltung an. Hierdurch läßt sich auf einfache Weise ein besonders großer, von den Wandabschnitten 3a begrenzter Zwischenraum bereitstellen, der dennoch ausreichend klein ist, um das Fluid kapillarisch zu transportieren. Die Porosität der kapillarischen Struktur ist hierdurch auf einfache Weise optimierbar.

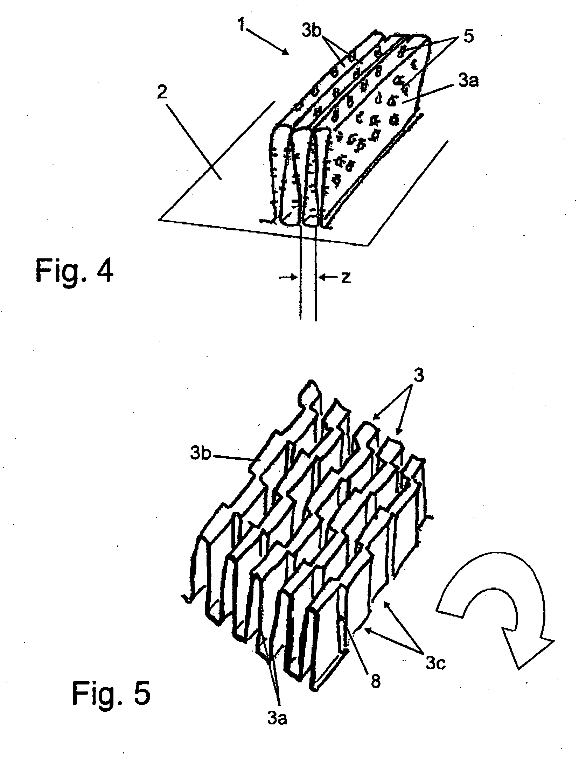

Fig. 4 zeigt eine Vorrichtung nach dem Stand der Technik, bei dem ein gefaltetes Blechformteil 1 nach dem Falten stark gerafft bzw. in Vorschubrichtung des Blechs komprimiert wurde, Die Abstände zwischen benachbarten Wandabschnitten 3a sind hierdurch ausreichend klein, um bereits ohne ein Umlegen der Faltungen 3 eine kapillarische Wirkung zu erreichen. Bei diese Vorrichtung Ausführungsbeispiel sind die Wandabschnitte 3a insbesondere im Wesentlichen senkrecht zu dem Tragteil 2 der Vorrichtung ausgerichtet. In der Vorrichtung umfasst das Blechformteil 1 zudem Durchbrechungen 5, wie sie im Ausführungsbeispiel nach Fig. 2 beschrieben wurden. Vorliegend beträgt der im Umbiegungsbereich 3b vorliegende größte Abstand z der Wandabschnitte 3a etwa 0,15 mm. Die gesamte Höhe des Blechformteils beträgt etwa 1,5 mm.

Fig. 5 zeigt eine räumliche Ansicht einer Stegrippen-Struktur. Derartige Blechformteile mit Stegrippen sind zumindest von der geometrischen Grundform her aus dem Bau von Wärmetauschern bekannt. Über die Länge einer Faltung 3 sind mehrere stegartige Abschnitte 3c ausgebildet, wobei zwischen zwei aufeinander folgenden Stegen 3c ein Versatz mit einer Durchbrechung 8 vorgesehen ist. Durch Umlegen der als Stegrippen ausgebildeten Faltungen 3 in Richtung des Pfeils können analog zum Ausführungsbeispiel gemäß Fig. 1 kapillarische Strukturen geschaffen werden.

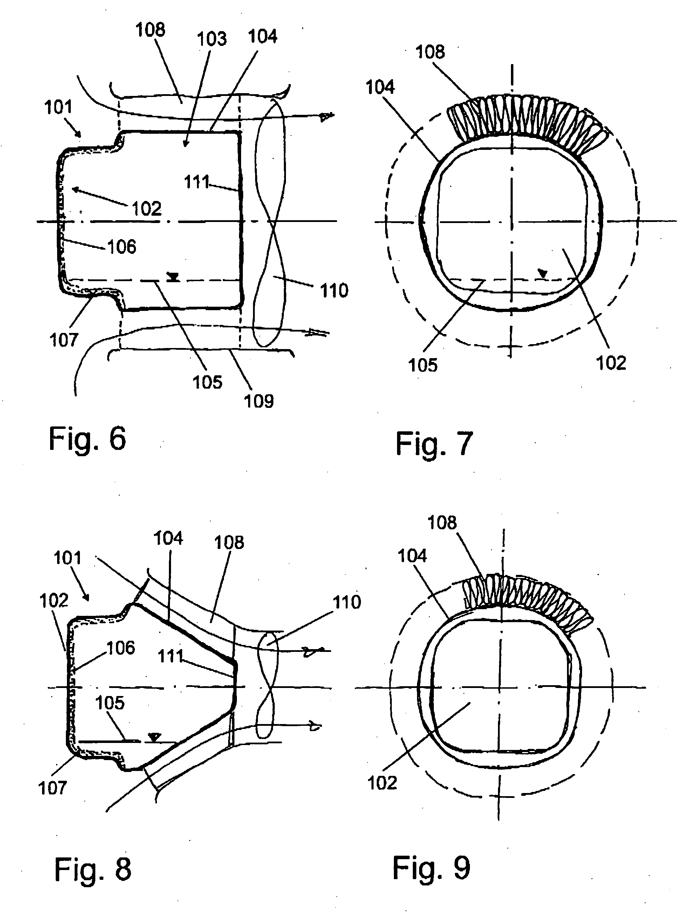

Fig. 6 zeigt eine Kühlvorrichtung nach dem Stand der Technik für eine Elektronikkomponente. Ein Gehäuse 101 schließt einen Hohlraum 103 ein und hat eine senkrecht ausgerichtete Wand 102, die außenseitig mit der (nicht dargestellten) Elektronikkomponente, zum Beispiel ein Mikroprozessor, flächig mit gutem thermischen Kontakt verbunden ist. Auf der inneren Oberfläche der Wand 102 ist eine erfindungsgemäße Vorrichtung zur Aufnahme eines Fluids 106 flächig aufgebracht, wodurch eine Verdampfungsfläche ausgebildet ist. Dabei kann die Vorrichtung 106 ein separates Tragteil 2 aufweisen oder auch durch unmittelbare Festlegung des Blechformteils 1 auf der Oberfläche der Wand 102 ausgebildet sein.

Ein vorliegend horizontal ausgerichteter, im Wesentlichen zylindrischer Wandabschnitt 104 schließt an die senkrechte Wand 102 an. Der Hohlraum 103 des Gehäuses 101 ist bis zu einer Füllstandhöhe 105 mit einem Fluid gefüllt, die einem Bruchteil der Gehäusehöhe entspricht. Ein Endbereich 107 der kapillarisch wirkenden Vorrichtung 106 taucht in das Fluid ein.

Außen ist an dem Wandabschnitt 104 eine umlaufende Berippung 108 angeordnet, wobei die gesamt Vorrichtung in einer Zarge 109 gehalten ist. Ein elektrischer Lüfter 110 ist vor einer senkrechten Abschlussfläche 111 des Gehäuses 101 angeordnet, wobei ein Luftstrom über die Berippung 108 erzeugbar ist. Hierdurch wird Wärme von dem Wandabschnitt 104 abgeführt.

Der Wandabschnitt 104 bildet eine im Wesentlichen glatte Kondensationsfläche für an der kapillarischen Vorrichtung 106 verdampfendes Fluid, wobei das kondensierte Fluid nach unten in sein Reservoir zurückläuft oder abtropft. Auf diese Weise wird über die Phasenumwandlung des Fluids eine gute Temperaturkonstanz der Wand 102 und somit des elektronischen Bauteils bereitgestellt. Zudem ist über die große Oberfläche der Kondensationsfläche 104 und der Berippung 108 eine hohe Wärmeleistung auf die kühlende Luft übertragbar.

Fig. 8 zeigt eine Abwandlung der Form des Gehäuses 101 bei sonst gleicher Funktion der Vorrichtung. Der Wandabschnitt 104 ist nicht zylindrisch, sondern verjüngt sich kegelstumpfförmig in Richtung des Lüfters 110. Hierdurch kann der Lüfter 110 einen kleineren Durchmesser aufweisen und die Luftströmung zwischen der Zarge 109 und der Wand 104 ist optimiert.

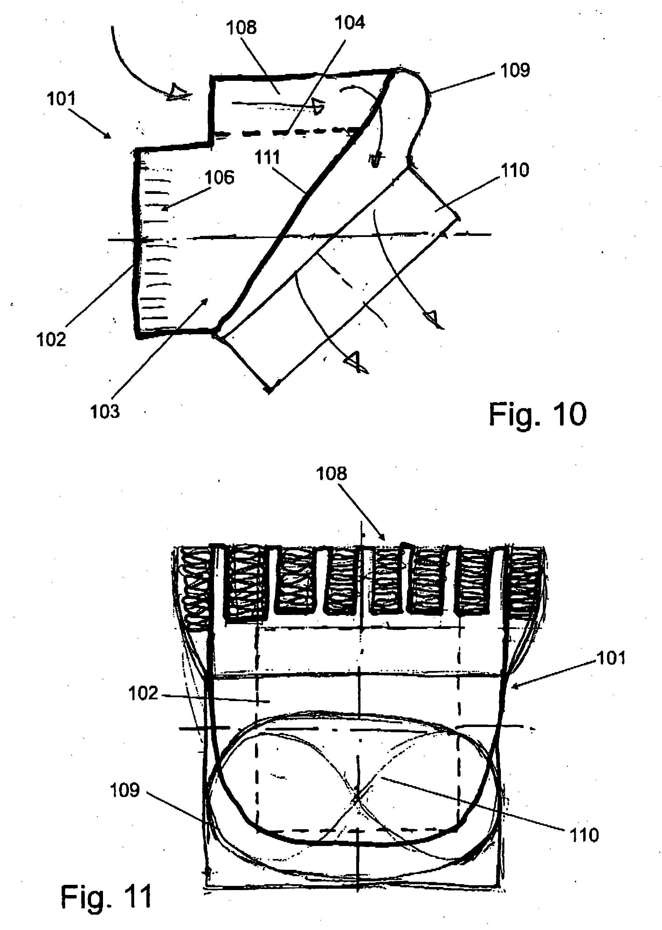

Fig. 10 zeigt eine weitere Abwandlung der Form des Gehäuses 101, die je nach Bauraumanforderungen geeignet sein kann. Hierbei befindet sich lediglich im oberen Bereich des Gehäuses 101 eine Berippung 108, wobei die Kondensationsfläche hauptsächlich durch eine an die Berippung 108 angrenzende obere Wand 104 des Gehäuses gebildet ist. Eine vordere Abschlusswand 111 des Gehäuses 101 ist relativ zu der senkrechten Verdampfungsfläche 102 geneigt und der wie in den anderen Beispielen saugend betriebene Lüfter 110 ist vor der geneigten Wand angeordnet. Der Luftstrom wird durch eine Zarge 109 über die Berippung 108 geleitet.

## Patentansprüche

1. Vorrichtung zur Aufnahme eines Fluids mittels Kapillarkräften, umfassend ein Tragteil (2) mit einer Oberfläche und
ein auf der Oberfläche festgelegtes Element mit einer kapillarischen Struktur, wobei das Element ein Blech- oder Metallfolienformteil (1) mit einer Mehrzahl von Faltungen (3) umfasst, wobei die kapillarische Struktur zumindest teilweise durch von den Faltungen (3) begrenzte Räume ausgebildet ist, wobei in dem Blechformteil (1) eine Mehrzahl von Durchbrechungen (4, 5, 6) ausgebildet ist und die Faltungen eine Dichte von zwischen etwa 150 und etwa 800 Faltungen/dm aufweisen, **dadurch gekennzeichnet, dass** die Faltungen (3) jeweils parallel zueinander verlaufende Wandabschnitte (3a) aufweist und die Wandabschnitte (3a) jeweils in einem Winkel zu der Oberfläche ausgerichtet sind, wobei der Winkel weniger als 90° beträgt.

2. Vorrichtung nach Anspruch 1, **dadurch gekennzeichnet, dass** das Blech- oder Metallfolienformteil (1) stoffschlüssig mit der Oberfläche verbunden ist.

3. Vorrichtung nach Anspruch 1, **dadurch gekennzeichnet, dass** der Winkel weniger als 45° beträgt.

4. Vorrichtung nach einem der vorhergehenden Ansprüche, **dadurch gekennzeichnet, dass** in dem Blechformteil (1) eine Mehrzahl von Vorsprüngen (7) ausgebildet ist.

5. Vorrichtung nach Anspruch 4, **dadurch gekennzeichnet, dass** die Vorsprünge in Form von Noppen (7) ausgebildet sind.

6. Vorrichtung nach Anspruch 4 oder 5, **dadurch gekennzeichnet, dass** die Durchbrechungen in Form von Ausstellungen (4) ausgebildet sind.

7. Vorrichtung nach einem der Ansprüche 4 bis 6, **dadurch gekennzeichnet, dass** Öffnungen oder Durchbrechungen im Bereich der Faltenkämme vorgesehen sind.

8. Vorrichtung nach einem der Ansprüche 4 bis 7, **dadurch gekennzeichnet, dass** durch eine Tiefe der Vorsprünge (7) und/oder Durchbrechungen (4, 5) ein Abstand benachbarter Faltungen (3) definiert ist.

9. Vorrichtung nach einem der vorhergehenden Ansprüche **dadurch gekennzeichnet, dass** das Blechformteil (1) Stegrippen (3c) aufweist.

10. Vorrichtung nach einem der vorhergehenden Ansprüche, **dadurch gekennzeichnet, dass** das Blechformteil (1) aus einem gut wärmeleitenden Metall besteht.

11. Vorrichtung nach einem der vorhergehenden Ansprüche, **dadurch gekennzeichnet, dass** das Blechformteil (1) aus einem Blech besteht, dessen Dicke weniger als etwa 0,1 mm beträgt.

12. Vorrichtung nach einem der vorhergehenden Ansprüche, **dadurch gekennzeichnet, dass** das Blechformteil (1) eine Beschichtung oder Oberflächenbehandlung aufweist, die eine gute Benetzbarkeit durch das Fluid aufweist.

13. Vorrichtung nach einem der vorhergehenden Ansprüche, **dadurch gekennzeichnet, dass** die Faltungen eine Höhe über der Oberfläche zwischen etwa 1 mm und etwa 6 mm.

14. Verfahren zur Herstellung einer Vorrichtung nach einem der Ansprüche 1 bis 13, umfassend die Schritte:
a. Vorsehen eines im Wesentlichen ebenen Bleches oder Folienhalbzeuges;
b. mehrfaches Falten des Bleches in im Wesentlichen der gleichen Ebene zur Erlangung einer Mehrzahl von benachbarten Faltungen (3), wobei die Faltungen eine Dichte von zwischen etwa 150 und etwa 800 Faltungen/dm aufweisen;
c. Aufbringen des gefalteten Bleches (1) auf der Oberfläche des Tragteils (2), wobei Durchbrechungen (4, 5, 6) in das Blech eingebracht werden, insbesondere vor der Durchführung von Schritt b,
**gekennzeichnet durch** den Schritt des Komprimierens der in Schritt b. erzeugten Faltungen (3), wobei die Faltungen (3) bezüglich der Oberfläche umgelegt werden, um Zwischenräume zwischen benachbarten Faltungswänden (3a) zu verringern.

15. Verfahren nach Anspruch 14, **dadurch gekennzeichnet, dass** das zumindest teilsweise Komprimieren vor Schritt c. erfolgt.

16. Verfahren nach Anspruch 14 oder 15, **dadurch gekennzeichnet, dass** das weitere Komprimieren durch Umlegen der Faltungen vor Schritt c. erfolgt.

17. Verfahren nach Anspruch 14, **dadurch gekennzeichnet, dass** das Komprimieren mittels eines Walzvorgangs erfolgt.

18. Verfahren nach einem der Ansprüche 14 bis 17, **gekennzeichnet durch** den Schritt des Einbringens von Vorsprüngen (7) in das Blech.

19. Verfahren nach Anspruch 18, **dadurch gekennzeichnet, dass** die Vorsprünge (7) und/oder Durchbrechungen (4, 5, 6) mittels eines Walzvorgangs in das Blech eingebracht werden.

20. Wärmerohr oder Sorptionsrohr, umfassend einen geschlossenen Hohlraum mit zwei räumlich getrennten Bereichen zur Beaufschlagung mit unterschiedlichen Temperaturen, wobei ein verdampfbares Fluid in dem Hohlraum angeordnet ist und wobei Mittel zum Halten und/oder Verteilen und/oder zum Transport des Fluids mittels Kapillarkräften in dem Hohlraum angeordnet sind,
**dadurch gekennzeichnet,**
**dass** die Mittel eine Vorrichtung nach einem der Ansprüche 1 bis 13 umfassen.

21. Kühlvorrichtung zur Kühlung einer Elektronikkomponente, umfassend ein Gehäuse (101) mit einem Hohlraum (103), wobei in dem Hohlraum (103) ein verdampfbares Fluid angeordnet ist,
eine Oberfläche (104) des Hohlraums (103), die als Kondensationsbereich für dampfförmiges Fluid ausgebildet ist,
einen Wandabschnitt (102) des Gehäuses zur thermisch leitfähigen Verbindung des Wandabschnitts mit einer Elektronikkomponente, und
ein Mittel zur Aufnahme des Fluids (106) innerhalb des Hohlraums (103) mittels Kapillarkräften,
**dadurch gekennzeichnet,**
**dass** die Mittel zur Aufnahme des Fluids eine Vorrichtung nach einem der Ansprüche 1 bis 13 umfassen.

22. Kühlvorrichtung nach Anspruch 21, **dadurch gekennzeichnet, dass** der Hohlraum eine Verdampfungsfläche (102) zur Verdampfung des Fluids aufweist, wobei die Mittel zur Aufnahme des Fluids (106) an der Verdampfungsfläche (102) angeordnet sind.

23. Kühlvorrichtung nach Anspruch 22, **dadurch gekennzeichnet, dass** zumindest ein Teil der Verdampfungsfläche (102) geneigt angeordnet ist.

24. Kühlvorrichtung nach Anspruch 23, **dadurch gekennzeichnet, dass** der äußere Wandabschnitt (102) geneigt angeordnet ist.

25. Kühlvorrichtung nach einem der Ansprüche 21 bis 24, **dadurch gekennzeichnet, dass** an dem Gehäuse (101) eine äußere Berippung (108) zum Austausch von Wärme mit Luft angeordnet ist.

26. Kühlvorrichtung nach einem der Ansprüche 21 bis 25, ferner umfassend einen Lüfter (110) zur Beströmung des Gehäuses mit Luft.

27. Kühlvorrichtung nach einem der Ansprüche 21 bis 26, **dadurch gekennzeichnet, dass** in dem Gehäuse eine kühlbare Kondensationsfläche (104) angeordnet ist, wobei dampfförmiges Fluid vorrangig an der Kondensationsfläche (104) kondensiert.

28. Kühlvorrichtung nach Anspruch 27, **dadurch gekennzeichnet, dass** die Kondensationsfläche (104) im Wesentlichen glatt ist.

29. Kühlvorrichtung nach Anspruch 27 oder 28, **dadurch gekennzeichnet, dass** an der Kondensationsfläche (104) keine Strukturen zur Aufnahme von Flüssigkeit mittels Kapillarkräften angeordnet sind.

## Claims

1. A device for absorbing a fluid via capillary forces, comprising a supporting part (2) having a surface, and
an element fastened to the surface and having a capillary structure,
the element comprising a sheet metal or metal foil molded part (1) having a plurality of folds (3), the capillary structure being formed at least in some regions by spaces delimited by the folds (3), a plurality of through-holes (4, 5, 6) being formed in the sheet metal molded part (1) and the folds having a thickness between approximately 150 and approximately 800 folds/dm, **characterized in that** the folds (3) in each case have wall sections (3a) extending parallel to one another and the wall sections (3a) in each case are oriented at an angle to the surface, wherein the angle is less than 90°.

2. The device according to claim 1, **characterized in that** the sheet metal or metal foil molded part (1) is bonded to the surface.

3. The device according to claim 1, **characterized in that** the angle is less than 45°.

4. A device according to any one of the preceding claims, **characterized in that** a plurality of projections (7) are configured in the sheet metal molded part (1).

5. The device according to claim 4, **characterized in that** the projections are configured in the form of nubs (7).

6. The device according to claim 4 or 5, **characterized in that** the through-holes are configured in the form of knockouts (4).

7. A device according to any one of claims 4 to 6, **characterized in that** openings or through-holes are provided in the region of the fold crests.

8. A device according to any one of claims 4 to 7, **characterized in that** a distance of adjoining folds (3) is defined by a depth of the projections (7) and/or through-holes (4, 5).

9. A device according to any one of the preceding claims, **characterized in that** the sheet metal molded part (1) has web ribs (3c).

10. A device according to any one of the preceding claims, **characterized in that** the sheet metal molded part (1) is made of an easily heat conducting material.

11. A device according to any one of the preceding claims, **characterized in that** the sheet metal molded part (1) is made of sheet metal having a thickness of less than approximately 0.1 mm.

12. A device according to any one of the preceding claims, **characterized in that** the sheet metal molded part (1) comprises a coating or surface treatment, which has good wettability by the fluid.

13. A device according to any one of the preceding claims, **characterized in that** the folds have a height above the surface between approximately 1 mm and approximately 6 mm.

14. A method for manufacturing a device according to any one of claims 1 to 13, comprising the following steps:
a. providing a substantially flat metal sheet or semi-finished foil product;
b. folding the metal sheet several times in substantially the same plane so as to obtain a plurality of adjoining folds (3), the folds having a thickness between approximately 150 and approximately 800 folds/dm;
c. applying the folded metal sheet (1) to the surface of the supporting part (2), thereby introducing through-holes (4, 5, 6) in the metal sheet, particularly prior to carrying out step b,
**characterized by** the step of compressing the folds (3) produced in step b, wherein the folds (3) are bent over with respect to the surface in order to reduce intermediate spaces between adjoining fold walls (3a).

15. The method according to claim 14, **characterized in that** the at least partial compression is carried out prior to step c.

16. The method according to claim 14 or 15, **characterized in that** further compression by bending over the folds is carried out prior to step c.

17. The method according to claim 14, **characterized in that** the compression is carried out by way of a rolling operation.

18. A method according to any one of claims 14 to 17, **characterized by** the step of introducing projections (7) into the metal sheet.

19. The method according to claim 18, **characterized in that** the projections (7) and/or through-holes (4, 5, 6) are introduced into the metal sheet by way of a rolling operation.

20. A heat tube or sorption tube, comprising an enclosed hollow space having two spatially separated regions to be subjected to different temperatures, a fluid that can be evaporated being provided in the hollow space, and means for holding and/or distributing and/or transporting the fluid by means of capillary forces being disposed in the hollow space,
**characterized in that**
the means comprise a device according to any one of claims 1 to 13.

21. A cooling device for cooling an electronic component, comprising a housing (101) having a hollow space (103), a fluid that can be evaporated being provided in the hollow space (103),
a surface (104) of the hollow space (103) which is designed as a condensation region for a vaporous fluid,
a wall section (102) of the housing for thermally conductively connecting the wall section to an electronics component, and
a means for receiving the fluid (106) inside the hollow space (103) by means of capillary forces,
**characterized in that**
the means for receiving the fluid comprise a device according to any one of claims 1 to 13.

22. The cooling device according to claim 21, **characterized in that** the hollow space has an evaporation surface (102) for evaporating the fluid, wherein the means for receiving the fluid (106) are disposed on the evaporation surface (102).

23. The cooling device according to claim 22, **characterized in that** at least part of the evaporation surface (102) is disposed at an incline.

24. The cooling device according to claim 23, **characterized in that** the outer wall section (102) is disposed at an incline.

25. A cooling device according to any one of claims 21 to 24, **characterized in that** outer ribs (108) are disposed on the housing (101) for the exchange of heat with air.

26. A cooling device according to any one of claims 21 to 25, further comprising a fan (110) for feeding air to the housing.

27. A cooling device according to any one of claims 21 to 26, **characterized in that** a condensation surface (104) that can be cooled is disposed in the housing, wherein vaporous fluid is primarily condensed on the condensation surface (104).

28. The cooling device according to claim 27, **characterized in that** the condensation surface (104) is substantially smooth.

29. The cooling device according to claim 27 or 28, **characterized in that** no structures for receiving fluid by means of capillary forces are disposed on the condensation surface (104).

## Revendications

1. Dispositif servant à la réception d'un fluide au moyen de forces capillaires, comprenant
une pièce support (2) comportant une surface, et
un élément, fixé sur la surface, comportant une structure capillaire,
où l'élément comprend une pièce usinée (1) en tôle ou en feuille métallique comportant une pluralité de plis (3), où la structure capillaire est configurée au moins partiellement par des espaces délimités par les plis (3), où une pluralité de percées (4, 5, 6) est configurée dans la pièce usinée en tôle (1), et les plis présentent une densité comprise entre à peu près 150 plis/dm et à peu près 800 plis/dm,
**caractérisé en ce que** les plis (3) présentent à chaque fois des parties de paroi (3a) s'étendant parallèlement entre elles, et les parties de paroi (3a) sont orientées à chaque fois en formant un angle par rapport à la surface, où l'angle est inférieur à 90°.

2. Dispositif selon la revendication 1, **caractérisé en ce que** la pièce usinée (1) en tôle ou en feuille métallique est assemblée à la surface par continuité de matière.

3. Dispositif selon la revendication 1, **caractérisé en ce que** l'angle est inférieur à 45°.

4. Dispositif selon l'une quelconque des revendications précédentes, **caractérisé en ce qu'**une pluralité de parties saillantes (7) est configurée dans la pièce usinée en tôle (1).

5. Dispositif selon la revendication 4, **caractérisé en ce que** les parties saillantes sont configurées sous la forme de tétons (7).

6. Dispositif selon la revendication 4 ou 5, **caractérisé en ce que** les percées sont configurées sous la forme de parties orientables (4).

7. Dispositif selon l'une quelconque des revendications 4 à 6, **caractérisé en ce que** des ouvertures ou des percées sont prévues dans la zone des crêtes de plis.

8. Dispositif selon l'une quelconque des revendications 4 à 7, **caractérisé en ce qu'**un intervalle entre des plis adjacents (3) est défini par une profondeur des parties saillantes (7) et / ou des percées (4, 5).

9. Dispositif selon l'une quelconque des revendications précédentes, **caractérisé en ce que** la pièce usinée en tôle (1) présente des nervures (3c) à âme pleine.

10. Dispositif selon l'une quelconque des revendications précédentes, **caractérisé en ce que** la pièce usinée en tôle (1) se compose d'un métal bon conducteur de la chaleur.

11. Dispositif selon l'une quelconque des revendications précédentes, **caractérisé en ce que** la pièce usinée en tôle (1) se compose d'une tôle dont l'épaisseur est inférieure à 0,1 mm environ.

12. Dispositif selon l'une quelconque des revendications précédentes, **caractérisé en ce que** la pièce usinée en tôle (1) a un revêtement ou un traitement de surface qui présente une bonne mouillabilité par le fluide.

13. Dispositif selon l'une quelconque des revendications précédentes, **caractérisé en ce que** les plis présentent une hauteur, au-dessus de la surface, comprise entre à peu près 1 mm et à peu près 6 mm.

14. Procédé de fabrication d'un dispositif selon l'une quelconque des revendications 1 à 13, comprenant les étapes consistant :
a. à prévoir une tôle pratiquement plane ou un demi-produit en feuille ;
b. à plier la tôle plusieurs fois, pratiquement dans le même plan, pour obtenir une pluralité de plis adjacents (3), où les plis présentent une densité comprise entre à peu près 150 plis/dm et à peu près 800 plis/dm ;
c. à appliquer la tôle pliée (1) sur la surface de la pièce support (2), où des percées (4, 5, 6) sont réalisées dans la tôle, en particulier avant l'exécution de l'étape b,
**caractérisé par** l'étape consistant à comprimer les plis (3) produits au cours de l'étape b., où les plis (3) sont renversés par rapport à la surface, pour diminuer des espaces intermédiaires formés entre des parois adjacentes (3a) des plis.

15. Procédé selon la revendication 14, **caractérisé en ce que** la compression, au moins partielle, se produit avant l'étape c.

16. Procédé selon la revendication 14 ou 15, **caractérisé en ce que** la suite du processus de compression, par renversement des plis, se produit avant l'étape c.

17. Procédé selon la revendication 14, **caractérisé en ce que** la compression se produit au moyen d'une opération de laminage.

18. Procédé selon l'une quelconque des revendications 14 à 17, **caractérisé par** l'étape consistant à introduire des parties saillantes (7) dans la tôle.

19. Procédé selon la revendication 18, **caractérisé en ce que** les parties saillantes (7) et / ou les percées (4, 5, 6) sont réalisées dans la tôle, au moyen d'une opération de laminage.

20. Tube de chaleur ou tube de sorption comprenant un espace creux fermé comportant deux zones spatialement séparées et prévues pour être sollicitées par des températures différentes, où un fluide évaporable est disposé dans l'espace creux et où des moyens servant à retenir et / ou à répartir et / ou à transporter le fluide, au moyen de forces capillaires, sont disposés dans l'espace creux, **caractérisé en ce que** les moyens comprennent un dispositif selon l'une quelconque des revendications 1 à 13.

21. Dispositif de refroidissement servant au refroidissement d'un composant électronique comprenant un carter (101) comportant un espace creux (103), où un fluide évaporable est disposé dans l'espace creux (103), une surface (104) de l'espace creux (103) qui est configurée comme une zone de condensation pour le fluide à l'état de vapeur,
une partie de paroi (102) faisant partie du carter et servant à la liaison thermoconductrice de la partie de paroi, avec un composant électronique, et
des moyens servant à la réception du fluide (106) à l'intérieur de l'espace creux (103), au moyen de forces capillaires,
**caractérisé en ce que** les moyens servant à la réception du fluide comprennent un dispositif selon l'une quelconque des revendications 1 à 13.

22. Dispositif de refroidissement selon la revendication 21, **caractérisé en ce que** l'espace creux présente une surface d'évaporation (102) servant à l'évaporation du fluide, où les moyens servant à la réception du fluide (106) sont disposés sur la surface d'évaporation (102).

23. Dispositif de refroidissement selon la revendication 22, **caractérisé en ce qu'**au moins une partie de la surface d'évaporation (102) est disposée de façon inclinée.

24. Dispositif de refroidissement selon la revendication 23, **caractérisé en ce que** la partie de paroi extérieure (102) est disposée de façon inclinée.

25. Dispositif de refroidissement selon l'une quelconque des revendications 21 à 24, **caractérisé en ce qu'**un nervurage extérieur (108) servant à l'échange de chaleur avec de l'air est disposé sur le carter (101).

26. Dispositif de refroidissement selon l'une quelconque des revendications 21 à 25, comprenant en outre un ventilateur (110) servant à faire circuler de l'air dans le carter.

27. Dispositif de refroidissement selon l'une quelconque des revendications 21 à 26, **caractérisé en ce qu'**une surface de condensation refroidissable (104) est disposée dans le carter, où un fluide à l'état de vapeur se condense, en premier, sur la surface de condensation (104).

28. Dispositif de refroidissement selon la revendication 27, **caractérisé en ce que** la surface de condensation (104) est pratiquement lisse.

29. Dispositif de refroidissement selon la revendication 27 ou 28, **caractérisé en ce qu'**aucune structure servant à la réception de fluide, à l'aide de forces capillaires, n'est disposée sur la surface de condensation (104).
